# EUROPEAN PATENT APPLICATION

(11) **EP 4 563 950 A1**
(43) Date of publication of application: **04.06.2025**
(21) Application number: 23845891.3
(22) Date of filing: 01.03.2023
(51) Int. Cl.: G01D 13/22, G01R 33/02

(54) **MAGNETIC FIELD DETECTION DEVICE**

(30) Priority: 27.07.2022 JP 2022119919
(71) Applicant: Alps Alpine Co., Ltd., Tokyo 145-8501 (JP)
(72) Inventor: KANAYA, Hiroki, Tokyo 145-8501 (JP); MIYAZAKI, Shun, Tokyo 145-8501 (JP)
(74) Representative: Maiwald GmbH
(86) International application number: PCT/JP2023/007577
(87) International publication number: WO 2024/024151

(57) **Abstract**

To provide a magnetic field detection device capable of adjusting a position of a magnetic sensor even after being attached to an existing device.

The magnetic field detection device includes: a lid body (110) that covers an opening (11A) of a housing(11), the housing having the opening and a space (11B) communicating with the opening; a magnet (130) disposed in the space and rotatable in the same plane as the opening in plan view; and a magnetic sensor (150) disposed on the lid body at a position facing the magnet and being apart from the magnet, and configured to detect a change in a magnetic field caused by rotation of the magnet. The lid body includes a position adjuster (112) capable of moving the magnetic sensor so as to change a facing distance (D) between the magnetic sensor and the magnet.

## Description

### TECHNICAL FIELD

The present disclosure relates to a magnetic field detection device.

### BACKGROUND ART

There is a motor including a magnetic field detection device having a disc-shaped magnet magnetized to a north pole and a south pole, a magnetic sensor disposed on a two-pole magnetizing polarization line of the magnet and opposed to the magnet, and a magnet holder for holding the magnet. The magnet holder includes a bottomed portion on which the magnet is disposed, and a threaded projection portion which is fitted into a threaded hole provided in a motor rotation shaft from the bottomed portion, and the bottomed portion has an outer shape which is symmetrical with respect to a magnetizing polarization line of the magnet. A fitting adjustment member for adjusting a fitting height is provided at a fitting position between the magnet holder and the motor rotation axis (for example, see Patent Document 1).

### RELATED ART DOCUMENTS

### PATENT DOCUMENT

Patent Document 1: Japanese Unexamined Patent Publication No. 2017-123731

### SUMMARY OF THE INVENTION

### PROBLEMS TO BE SOLVED BY THE INVENTION

A conventional magnetic field detection device adjusts a position of a magnet with respect to a magnet holder, but cannot adjust a position of a magnetic sensor. For example, in the case where a magnet is provided inside a housing of an existing device or the like and a magnetic sensor is provided outside the housing, the distance between the magnet and the magnetic sensor cannot be adjusted after the conventional magnetic field detection device is attached to the existing device.

Under such a circumstance, a magnetic field detection device capable of adjusting a position of a magnetic sensor even after being attached to an existing device is desired.

### MEANS FOR SOLVING THE PROBLEMS

A magnetic field detection device of an embodiment of the present disclosure includes: a lid body that covers an opening of a housing, the housing having the opening and a space communicating with the opening; a magnet disposed in the space and rotatable in the same plane as the opening in plan view; and a magnetic sensor disposed on the lid body at a position facing the magnet and being apart from the magnet, and configured to detect a change in a magnetic field caused by rotation of the magnet. The lid body includes a position adjuster capable of moving the magnetic sensor so as to change a facing distance between the magnetic sensor and the magnet.

### EFFECTS OF THE INVENTION

A magnetic field detection device capable of adjusting a position of a magnetic sensor even after being attached to an existing device can be provided.

### BRIEF DESCRIPTION OF THE DRAWINGS

[FIG. 1] FIG. 1 is a diagram illustrating an example of an analog meter to which a magnetic field detection device of an embodiment is applied.
[FIG. 2A] FIG. 2A is a diagram illustrating an example of a cross-sectional structure of the analog meter to which the magnetic field detection device of the embodiment is applied.
[FIG. 2B] FIG. 2B is a diagram illustrating an example of a cross-sectional structure of the analog meter to which the magnetic field detection device of the embodiment is applied.
[FIG. 3A] FIG. 3A is a diagram illustrating an example of a cross-sectional structure of an analog meter to which a magnetic field detection device of a modified example of the embodiment is applied.
[FIG. 3B] FIG. 3B is a diagram illustrating an example of a cross-sectional structure of the analog meter to which the magnetic field detection device of the modified example of the embodiment is applied.

### DESCRIPTION OF EMBODIMENTS

Hereinafter, embodiments to which the magnetic field detection device of the present disclosure is applied will be described.

### <Embodiment>

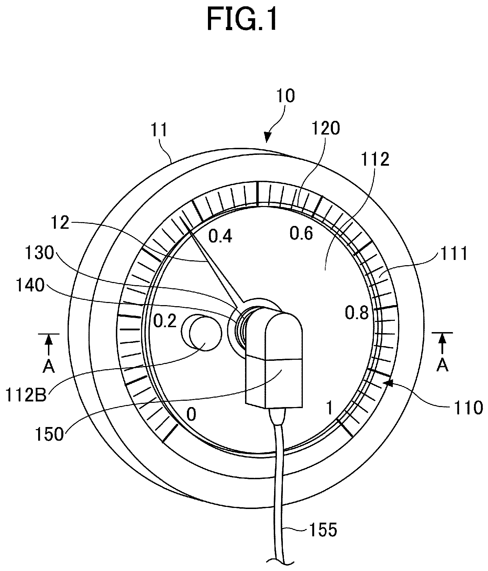

FIG. 1 is a diagram illustrating an example of an analog meter 10 to which a magnetic field detection device 100 of the embodiment is applied. The magnetic field detection device 100 is a device that can be attached to an existing device after the existing device is manufactured or installed. In the descriptions hereinafter, an analog meter 10 will be an example of an existing device. The existing device is a device that has been already manufactured and completed.

The analog meter 10 is a gas meter as an example but is not limited to the gas meter, and may be a meter that indicates various physical quantities related to water, electric power, and the like, for example. The analog meter 10 is installed in, for example, a factory or the like, and indicates measurement results of various physical quantities.

The analog meter 10 includes a housing 11 and a needle 12. The magnetic field detection device 100 includes a glass lid 110, a rubber bushing 120, a magnet 130, a fixing implement 140, and a magnetic sensor 150. The glass lid 110 is an example of a lid body, and the rubber bushing 120 is an example of a waterproof member.

The glass lid 110 has a configuration that can be replaced with an existing glass lid (lid body) of the analog meter 10. In order for the glass lid 110 to be replaceable with an existing glass lid of the analog meter 10, the diameter and thickness of the glass lid 110 need to be equal to the diameter and thickness of the existing glass lid. Since the diameter and thickness of the glass lid differ depending on the type of the analog meter 10, the glass lid 110 may be designed in accordance with the type of the analog meter 10.

FIG. 1 illustrates a state in which the existing glass lid of the analog meter 10 is replaced with the glass lid 110 of the magnetic field detection device 100, the magnet 130 is attached to the needle 12 by the fixing implement 140, and the magnetic sensor 150 is attached to the outer surface of the glass lid 110.

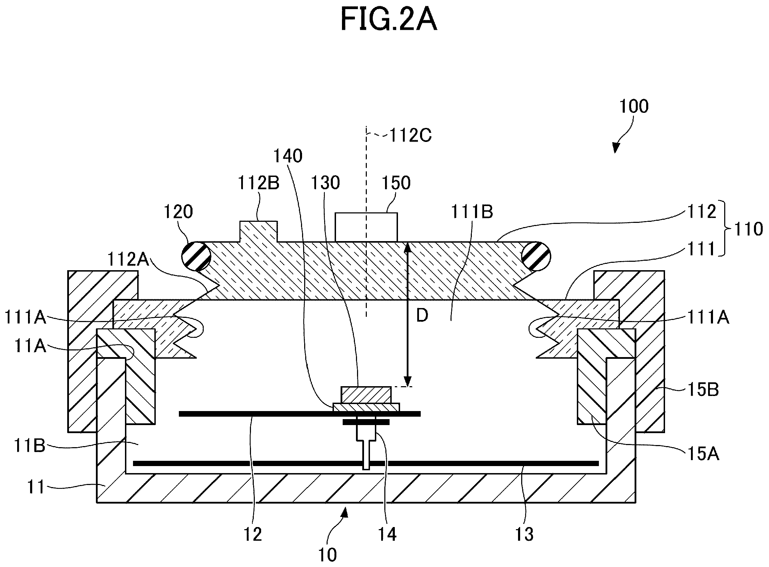

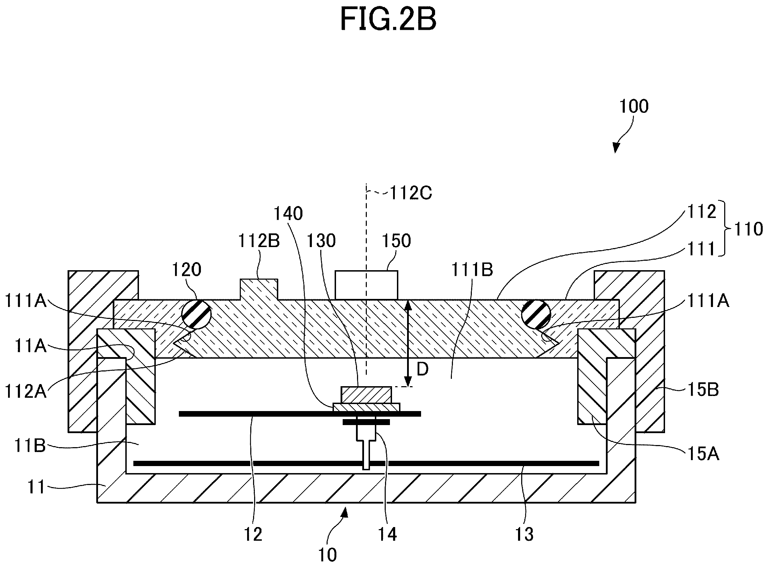

The configuration of each constituent element will be described hereinafter with reference to FIG. 1 and FIGS. 2A and 2B. FIG. 2A and FIG. 2B are diagrams illustrating an example of a cross-sectional structure of the analog meter 10 to which the magnetic field detection device 100 is applied. FIG. 2B illustrates a cross section taken along line A-A of FIG. 1, and FIG. 2A illustrates a state where the glass lid 110 is disassembled in the cross section taken along line A-A of FIG. 1. The cross sections illustrated in FIG. 2A and 2B are a cross section including a rotation axis 112C of the adjustment lid 112 and a rotation axis of the magnet 130, both of which will be described later. The rotation axis of the magnet 130 is the rotation shaft 14 of the needle 12.

In the following description, the vertical direction in FIG. 2A and FIG. 2B may be used for description, but this does not indicate an absolute vertical relationship. In the following description, the term "plan view" means a plan view of an opening 11A of the housing 11 of the analog meter 10.

The analog meter 10 includes a dial plate 13 and a rotation shaft 14 in addition to the housing 11 and the needle 12. The housing 11 has, for example, a bottomed cylindrical shape, and includes an opening 11A provided in an upper portion and a space 11B communicating with the opening 11A. The dial plate 13 is disposed on the bottom of the space 11B, and the needle 12 is rotatable in the same plane as the dial plate 13 in plan view by the rotation shaft 14 provided on the dial plate 13. The dial plate 13 is a disc-shaped member, and characters, numbers, and the like to indicate measurements are inscribed on the upper surface of the dial plate 13. The rotation shaft 14 is provided at the center of the dial plate 13 in plan view in a rotatable manner with respect to the dial plate 13. The rotation shaft 14 is a rotation axis of the needle 12, and extends in a direction perpendicularly penetrating the center of the opening 11A in plan view, for example.

The glass lid 110 is a transparent panel formed of a transparent glass plate and having a disc shape. The analog meter 10 can be read remotely by using the magnetic field detection device 100, but can also be directly viewed by an operator or the like; therefore, the glass lid 110 is preferably transparent. Although the "glass" lid is described in the present embodiment, the glass lid may be formed of resin or the like as long as the glass lid has transparency to the extent that the dial plate of the analog meter 10 including the needle 12 can be visually recognized.

The glass lid 110 includes a fixing lid 111 and an adjustment lid 112. The adjustment lid 112 is an example of a position adjuster and is attached to the fixing lid 111. The fixing lid 111 is an example of a fixed portion that is a portion of the glass lid 110 (an example of a lid body) other than the adjustment lid 112 (an example of a position adjuster). The transmittance of the fixing lid 111 and that of the adjustment lid 112 are the same, for example. This is to allow an operator or the like to view the dial plate uniformly through the glass lid 110 including the fixing lid 111 and the adjustment lid 112 as a whole, without giving them discomfort.

The fixing lid 111 is a transparent panel having an annular shape in plan view, and holds the adjustment lid 112 in the centrally located opening 111B. Screw threads 111A are formed on an inner peripheral wall enclosing the centrally opening 111B of the fixing lid 111. The screw threads 111A can be formed by tapping, for example. The fixing lid 111 is replaced with an existing glass lid (lid body) of the analog meter 10, and is fixed to the housing 11 by annular fixing portions 15A and 15B. The fixing lid 111 covers the outer peripheral edge portion of the opening 11A. The fixing portions 15A and 15B may have any configuration as long as they can fix the fixing lid 111 to the housing 11; for example, the fixing portions 15A and 15B may have engaging portions, such as screw threads or protrusions, formed thereon to fasten the fixing lid 111.

The adjustment lid 112 is a disc-shaped transparent panel rotatably attached to the centrally located opening 111B of the fixing lid 111. The adjustment lid 112 has screw threads 112A formed on the outer peripheral portion and a grip portion 112B provided at a position offset from the center of the upper surface, and the magnetic sensor 150 is attached to the center of the upper surface of the adjustment lid 112. The upper surface of the adjustment lid 112 is an outer surface located outside the analog meter 10. The screw threads 112A can be formed by tapping, for example.

The adjustment lid 112 is attached to the fixing lid 111 as illustrated in FIG. 2B by aligning the adjustment lid 112 with the opening 111B from the upper side of the fixing lid 111 as illustrated in FIG. 2A and rotating the adjustment lid 112 around the rotation axis 112C in plan view, with fastening the screw threads 112A of the outer peripheral portion to the screw threads 111A of the fixing lid 111. Fastening the screw threads 112A to the screw threads 111A is screwing the screw threads 112A to the screw threads 111A.

When the screw threads 112A are fastened to the screw threads 111A, an annular rubber bushing 120 is fitted between the screw threads 112A and the screw threads 111A. Since the adjustment lid 112 is attached to the opening 111B at the center of the fixing lid 111, the glass lid 110 constituted by the fixing lid 111 and the adjustment lid 112 covers the opening 11A of the housing 11.

The adjustment lid 112 can be rotated by pinching the grip portion 112B with fingers or the like. For this reason, the grip portion 112B is provided at a position offset from the center of the adjustment lid 112 in plan view. The grip portion 112B is a protrusion projecting from the upper surface of the adjustment lid 112.

The rotation axis 112C of the adjustment lid 112 coincides with the central axis of the opening 111B of the fixing lid 111, and coincides with the rotation shaft 14 of the needle 12, which is the rotation axis of the magnet 130. The upper surface and the lower surface of the adjustment lid 112 are parallel to the upper surface of the dial plate 13 and are also parallel to a plane including an orbit of a rotation of the needle 12.

The position of the adjustment lid 112 with respect to the fixing lid 111 in the direction along the rotation axis 112C (the vertical direction in FIG. 2A and FIG. 2B) can be adjusted by rotating the adjustment lid 112. A distance D between the magnetic sensor 150 on the upper surface of the adjustment lid 112 and the magnet 130 can be thus adjusted by rotating the adjustment lid 112. The distance D between the magnetic sensor 150 and the magnet 130 is a facing distance at which the magnetic sensor 150 faces the magnet 130. The adjustment lid 112 can move the magnetic sensor 150 in the vertical direction so as to change the distance D (facing distance) between the magnetic sensor 150 and the magnet 130.

Since the rotation axis 112C of the adjustment lid 112 and the rotation axis of the magnet 130 coincide with each other, when the distance D between the magnetic sensor 150 attached to the center of the upper surface of the adjustment lid 112 and the magnet 130 is adjusted, it is possible to adjust only the distance D, with the positional relationship between the magnetic sensor 150 and the magnet 130 in plan view being maintained.

In order to detect a change in the direction of the magnetic field caused by a rotation of the magnet 130 by the magnetic sensor 150, the magnetic sensor 150 is desirably disposed as close as possible to the magnet 130; however, since there are manufacturing errors, mounting errors, and the like of the housing 11, the needle 12, or the dial plate 13, it is necessary to adjust the position of the magnetic sensor 150 in the vertical direction. With a use of the glass lid 110 having the adjustment lid 112 whose position in the vertical direction can be adjusted by rotating the adjustment lid 112 with respect to the fixing lid 111, it is possible to easily adjust the position of the magnetic sensor 150 with respect to the magnet 130 in the vertical direction only by rotating the adjustment lid 112 from the outside of the analog meter 10 after the magnetic field detection device 100 is attached to the analog meter 10. Therefore, a change in the direction of the magnetic field of the magnet 130 caused by a rotation of the needle 12 can be accurately and reliably detected.

The rubber bushing 120 is an annular rubber member, and has an outside diameter corresponding to the screw threads 111A and an inside diameter corresponding to the screw threads 112A. For this reason, the rubber bushing 120 can be sandwiched between the screw threads 111A and the screw threads 112A, and the space between the screw threads 111A and the screw threads 112A can be sealed. An area between the screw threads 111A and the screw threads 112A is a boundary portion between the fixing lid 111 and the adjustment lid 112. The analog meter 10 can be read remotely by using the magnetic field detection device 100, but the analog meter 10 may be directly viewed by an operator or the like; therefore, the rubber bushing 120 is preferably transparent in order to improve the visibility of the dial plate. In the present embodiment, the rubber bushing is used as a waterproof member, but the waterproof member is not limited to this; it is sufficient that the waterproof member can prevent water from entering from the boundary portion between the fixing lid 111 and the adjustment lid 112, and for example, the waterproof member may be realized by applying a film across the fixing lid 111 and the adjustment lid 112, applying a curable resin, or arranging an additional transparent case covering the glass lid 110.

The analog meter 10 can realize a waterproof structure because the housing 11 and the glass lid 110 are sealed by the fixing portions 15A and 15B, and the rubber bushing 120 seals between the fixing lid 111 and the adjustment lid 112 of the glass lid 110. The waterproof structure can prevent water, dust, and the like from entering the inside of the analog meter 10 to which the magnetic field detection device 100 is attached. Since the analog meter 10 may be installed in a place outdoors without a roof, having the waterproof structure allows the analog meter 10 to be stably operated for a long period of time.

The magnet 130 is a permanent magnet having a north pole and a south pole. The magnet 130 is fixed on the rotation shaft 14 on the upper surface of the needle 12 by the fixing implement 140. Therefore, the magnet 130 is disposed in the space 11B of the housing 11 and is rotatable in the same plane as the space 11B in plan view in accordance with the rotation of the needle 12. The magnet 130 is fixed on the rotation shaft 14 on the upper surface of the needle 12 in such a manner that the north pole and the south pole are adjacent to each other in a plane including an orbit of a rotation of the needle 12, for example.

The fixing implement 140 is a member that fixes the magnet 130 on the rotation shaft 14 on the upper surface of the needle 12. As such a fixing implement 140, for example, a magnet fixing implement described in the specification and drawings of International Publication No. WO 2021/200947 can be used.

The magnetic sensor 150 is attached to the adjustment lid 112 at the center of the upper surface. In other words, the magnetic sensor 150 is disposed on the glass lid 110 at a position facing the magnet 130 and being separated from the magnet 130. The magnetic sensor 150 is attached to the upper surface of the adjustment lid 112 by an adhesive, a double-sided tape, or the like. The magnetic sensor 150 is supplied with power via a cable 155 and is connected to, for example, a wireless communication device via a cable 155.

The magnetic sensor 150 detects the direction of a magnetic field generated by a rotation of the magnet 130. The direction of the magnetic field detected by the magnetic sensor 150 is a rotation angle of the needle 12, and represents a pressure, an amount of use, or the like of the gas in the case where the analog meter 10 is a gas meter. The magnetic sensor 150 outputs a rotation angle detection signal indicating a rotation angle of the needle 12 to the wireless communication device via the cable 155. The wireless communication device transmits a rotation angle detection signal to a management device that manages rotation angle detection signals. The magnetic sensor 150 detects a rotation angle detection signal at predetermined time intervals. The management device can remotely read the angle of the needle 12 of the analog meter 10.

### <Effects>

The magnetic field detection device 100 includes a glass lid 110 covering an opening 11A of a housing 11 having the opening 11A and a space 11B communicating with the opening 11A, a magnet 130 disposed in the space 11B and rotatable in the same plane as the opening 11A in plan view, and a magnetic sensor 150 disposed on the glass lid 110 at a position facing the magnet 130 and being apart from the magnet 130 and detecting changes in magnetic fields caused by a rotation of the magnet 130, wherein the glass lid 110 has an adjustment lid 112 capable of moving the magnetic sensor 150 so as to change a facing distance (distance D) between the magnetic sensor 150 and the magnet 130. Thus, the magnetic field detection device 100 can be attached to an existing analog meter 10 by removing the existing glass lid of the existing analog meter 10, attaching the magnet 130 to the needle 12 with the fixing implement 140, attaching the glass lid 110 instead of the existing glass lid, and attaching the magnetic sensor 150 to the outer surface of the glass lid 110. The position of the magnetic sensor 150 with respect to the magnet 130 can be adjusted by rotating the adjustment lid 112 to adjust the position in the vertical direction with respect to the fixing lid 111.

Therefore, it is possible to provide the magnetic field detection device 100 capable of adjusting the position of the magnetic sensor 150 even after the magnetic field detection device 100 is attached to the analog meter 10, which is an existing device.

After the magnetic field detection device 100 is attached to the analog meter 10, the adjustment lid 112 can be rotated from the outside of the analog meter 10. Thus, the position of the magnetic sensor 150 in the vertical direction with respect to the magnet 130 can be easily adjusted by rotating the adjustment lid 112 with respect to the fixing lid 111, in accordance with a manufacturing error, an attachment error, or the like of the housing 11, the needle 12, or the dial plate 13. In order for the magnetic sensor 150 to detect the change in the direction of the magnetic field caused by the rotation of the magnet 130, the magnetic sensor 150 is desirably disposed as close as possible to the magnet 130. Therefore, by disposing the magnetic sensor 150 at an appropriate position, the change in the direction of the magnetic field of the magnet 130 caused by the rotation of the needle 12 can be accurately and reliably detected.

It is also conceivable to adjust the position of the magnet 130 in the vertical direction by, for example, inserting a holder or the like under the magnet 130. However, since the distance between the magnet 130 and the magnetic sensor 150 varies depending on the analog meter 10, in such a case of using a holder, it is necessary to prepare a plurality of types of holders having different sizes according to the distance, which increases the cost. It is also conceivable to prepare a plurality of types of glass lids having different thicknesses and to adjust the position of the magnet 130 in the vertical direction by replacing the existing glass lid of the analog meter 10 with one of the prepared lids; however, even in such a method, the preparation of the glass lids having different thickness would increase the cost.

In contrast, the magnetic field detection device 100 can easily adjust the position of the magnetic sensor 150 in the vertical direction with respect to the magnet 130 only by rotating the adjustment lid 112 from the outside of the analog meter 10, after the magnetic field detection device 100 is attached to the analog meter 10, and thus the cost for attaching the magnetic field detection device 100 to the analog meter 10 can be significantly reduced.

Since the position of the magnetic sensor 150 in the vertical direction with respect to the magnet 130 can be easily adjusted only by rotating the adjustment lid 112, the thickness of the adjustment lid may differ from that of the existing glass lid of the analog meter 10, as long as the diameter of the adjustment lid is the same as that of the existing glass lid. Therefore, the magnetic field detection device 100 can be attached to a plurality of types of analog meter 10 having different thicknesses for an existing glass lid.

The magnetic sensor 150 is disposed on the adjustment lid 112, and the adjustment lid 112 is screwed to the glass lid 110 and is movable so as to change the facing distance (distance D) by rotating around the rotation axis 112C in a direction along the opening 11A in plan view. Therefore, after the magnetic field detection device 100 is attached to the analog meter 10, the position of the magnetic sensor 150 in the vertical direction with respect to the magnet 130 can be easily adjusted by simply rotating the adjustment lid 112.

Since the rubber bushing 120 for preventing water from entering through the boundary portion between the glass lid 110 and the adjustment lid 112 is further included, a waterproof structure can be realized, and water, dust, and the like can be prevented from entering the inside of the analog meter 10 to which the magnetic field detection device 100 is attached. Even if the analog meter 10 is installed in a place outdoors without a roof, the analog meter 10 can be stably operated for a long period of time.

Since the glass lid 110 and the adjustment lid 112 are transparent panels, the visibility is good when an operator or the like directly views the analog meter 10.

Since the rotation axis 112C of the adjustment lid 112 coincides with the rotation shaft 14 of the magnet 130, when the distance D between the magnet 130 and the magnetic sensor 150 attached to the adjustment lid 112 at the center of the upper surface is adjusted, only the distances D can be adjusted while maintaining the positional relationship between the magnetic sensor 150 and the magnet 130 in plan view.

Since the adjustment lid 112 has the grip portion 112B provided on the outer surface side, the adjustment lid 112 can be easily rotated by pinching the grip portion 112B with fingers or the like, and the position of the magnetic sensor 150 in the vertical direction with respect to the magnet 130 can be easily adjusted.

The fixing implement 140 for fixing the magnet 130 to the analog meter 10 is further provided, and the housing 11 is the housing 11 of the analog meter 10, the glass lid 110 has a configuration that can be replaced with the existing glass lid 110 of the analog meter 10, and the magnet 130 is rotatable in the same plane as the opening 11A in plan view by being fixed to the needle by the fixing implement 140. Therefore, the magnet 130 can be easily attached to the needle 12 by the fixing implement 140, and the rotation angle of the needle 12 can be easily detected by the magnetic sensor 150 by effectively using the housing 11 of the existing analog meter 10.

### <Modified Example>

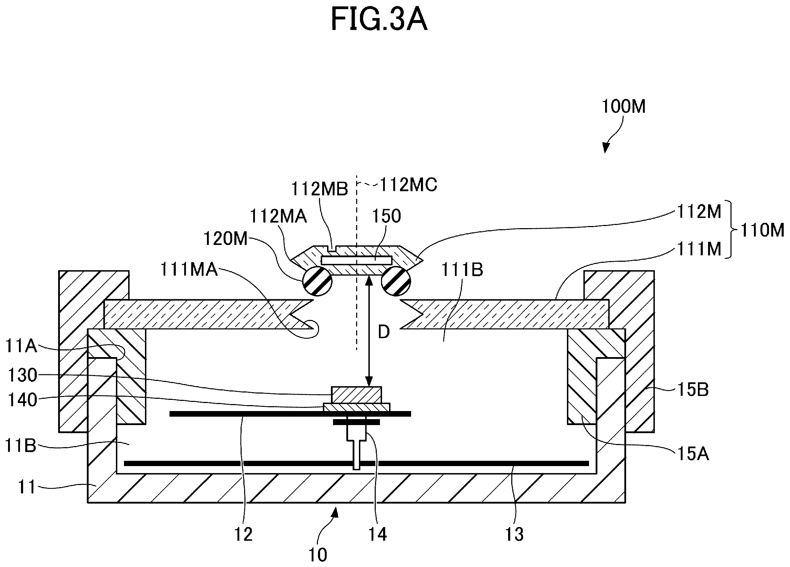

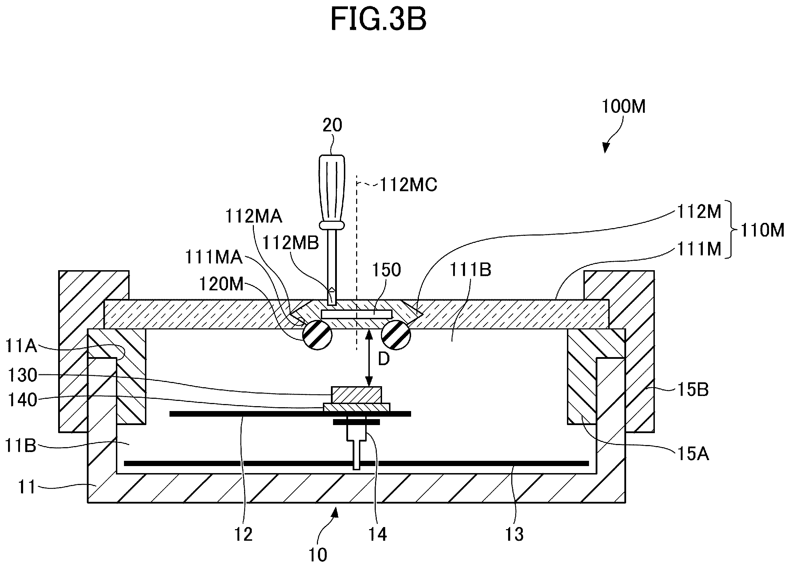

FIG. 3A and FIG. 3B are diagrams illustrating an example of a cross-sectional structure of an analog meter 10 to which a magnetic field detection device 100M of a modified example of the embodiment is applied. FIG. 3B illustrates a cross section corresponding to the cross section taken along line A-A of FIG. 1, and FIG. 3A illustrates a state where the glass lid 110M is disassembled. The cross sections illustrated in FIG. 3A and 3B are a cross section including a rotation axis 112MC of the adjustment lid 112M and a rotation axis of the magnet 130, both of which will be described later. Hereinafter, differences from the magnetic field detection device 100 illustrated in FIGS. 1, 2A, and 2B will be described, and the same components as those of the magnetic field detection device 100 are denoted by the same symbols and the description thereof will be omitted.

The magnetic field detection device 100 includes a glass lid 110, a rubber bushing 120, a magnet 130, a fixing implement 140, and a magnetic sensor 150. The magnetic field detection device 100M has a configuration in which the glass lid 110 and the rubber bushing 120 of the magnetic field detection device 100 are replaced with a glass lid 110M and a rubber bushing 120M, respectively.

The glass lid 110M has a fixing lid 111M and an adjustment lid 112M. The fixing lid 111M is a transparent panel having an annular shape in plan view, similarly to the fixing lid 111 illustrated in FIGS. 1, 2A, and 2B, but the annular portion is longer in the radial direction and the opening 111MB is smaller than that of the fixing lid 111. Screw threads 111MA are formed on an inner peripheral wall enclosing the central opening 111MB of the fixing lid 111M.

The adjustment lid 112M is a case covering the magnetic sensor 150, and is formed of a disc-shaped transparent panel. The adjustment lid 112M has the screw threads 112MA formed on the outer peripheral part, a recess 112MB provided at a position offset from the center of the upper surface, and a rotation axis 112MC, and is screwed to the screw threads 112A of the fixing lid 111M.

To attach the adjustment lid 112M to the fixing lid 111M as illustrated in FIG. 3B, the adjustment lid 112M is aligned with the opening 111MB from the upper side of the fixing lid 111M as illustrated in FIG. 3A and rotated around the rotation axis 112MC in plan view, while ensuring that the screw threads 112MA of the outer peripheral portion fasten to the screw threads 111MA of the fixing lid 111M. The magnetic sensor 150 is attached to the glass lid 110M by screwing the adjustment lid 112M to the fixing lid 111M.

When the screw threads 112MA are fastened to the screw threads 111MA, an annular rubber bushing 120M is fitted between the screw threads 112MA and the screw threads 111MA. The inside diameter and the outside diameter of the rubber bushing 120M are smaller than those of the rubber bushing 120 illustrated in FIGS. 1, 2A, and 2B. Since the adjustment lid 112M is attached to the opening 111MB at the center of the fixing lid 111M, the glass lid 110M, which is made up of the fixing lid 111M and the adjustment lid 112M, covers the opening 11A of the housing 11.

Since the adjustment lid 112M as a case for covering the magnetic sensor 150 is rotatable with respect to the fixing lid 111M, the distance D between the magnet 130 and the magnetic sensor 150 can be rotated to adjust the adjustment lid 112M.

When the adjustment lid 112M is rotated, a rod-like member having a thin tip such as a flathead screwdriver 20 may be inserted into the recess 112MB and rotated. For this reason, the recess 112MB is provided at a position offset from the center of the adjustment lid 112M in plan view. The recess 112MB is recessed from the upper surface of the adjustment lid 112M. The recess 112MB may be disposed so as to be coaxial with the rotation axis 112MC, without being offset from the center of the adjustment lid 112M in plan view. In this case, the distance D can be easily adjusted by fastening the adjustment lid 112M with a screwdriver or the like.

The magnetic field detection device 100M can be attached to the existing analog meter 10 by removing the existing glass lid of the existing analog meter 10, attaching the magnet 130 to the needle 12 with the fixing implement 140, and attaching the glass lid 110M instead of the existing glass lid. The position of the magnetic sensor 150 with respect to the magnet 130 can be adjusted by rotating the adjustment lid 112M to adjust the position in the vertical direction with respect to the fixing lid 111M.

Therefore, it is possible to provide the magnetic field detection device 100M capable of adjusting the position of the magnetic sensor 150, even after the magnetic field detection device 100M is attached to the analog meter 10, which is an existing device.

The adjustment lid 112M is a case of the magnetic sensor 150, and the magnetic sensor 150 is attached to the glass lid 110M by screwing the case to the glass lid 110M, and therefore, the magnetic sensor 150 is easily mounted.

Since the adjustment lid 112M as the case of the magnetic sensor 150 has the recess 112MB provided on the outer surface side, the adjustment lid 112M can be easily rotated by inserting a rod-shaped member having a thin tip, such as the flathead screwdriver 20, into the recess 112MB, and the position of the magnetic sensor 150 in the vertical direction with respect to the magnet 130 can be easily adjusted.

Although the magnetic field detection device according to the exemplary embodiment of the present disclosure has been described above, the present disclosure is not limited to the specifically disclosed embodiment, and various modifications and changes can be made without departing from the scope of the claims.

The present international application claims priority based on Japanese Patent Application No. 2022-119919 filed on July 27, 2022, the entire contents of which are incorporated herein by reference.

### REFERENCE SIGNS LIST

10 Analog meter (an example of an existing device)
11 Housing
12 Needle
13 Dial plate
14 Rotation axis (an example of a rotation axis of a magnet)
15A, 15B Fixing portion
100, 100M Magnetic field detection device
110, 110M Glass lid
111 Fixing lid (an example of a fixing portion)
111A, 111MA Screw threads
111B, 111MB Opening
112, 112M Adjustment lid
112A, 112MA Screw threads
112B Grip portion
112MB Recess
112C Rotation axis (an example of a rotation axis of a position adjuster)
120, 120M Rubber bushing (an example of a waterproof member)
130 Magnet
140 Fixing implement
150 Magnetic sensor

## Claims

1. A magnetic field detection device comprising:
a lid body that covers an opening of a housing, the housing having the opening and a space communicating with the opening;
a magnet disposed in the space and rotatable in a same plane as the opening in plan view; and
a magnetic sensor disposed on the lid body, facing the magnet and located apart from the magnet, and configured to detect a change in a magnetic field caused by rotation of the magnet, wherein
the lid body includes a position adjuster capable of moving the magnetic sensor so as to change a facing distance between the magnetic sensor and the magnet.

2. The magnetic field detection device according to claim 1, wherein
the magnetic sensor is disposed on the position adjuster, and
the position adjuster is screwed to the lid body, and is movable so as to change the facing distance by rotating around a rotation axis in a direction along the opening in plan view.

3. The magnetic field detection device according to claim 2, wherein
the position adjuster is a case of the magnetic sensor, and the magnetic sensor is attached to the lid body by screwing the case to the lid body.

4. The magnetic field detection device according to claim 1, further comprising:
a waterproof member that prevents water from entering through a boundary portion between a fixing portion and the position adjuster, the fixing portion being a portion of the lid body other than the position adjuster.

5. The magnetic field detection device according to claim 1, wherein
each of a fixing portion that is a portion of the lid body other than the position adjuster, and the position adjuster are a transparent panel.

6. The magnetic field detection device according to any one of claims 1 to 5, wherein
a rotation axis of the position adjuster and a rotation axis of the magnet coincide with each other.

7. The magnetic field detection device according to claim 1, wherein
the position adjuster has a grip portion provided on an outer surface side thereof.

8. The magnetic field detection device according to claim 3, wherein
a case of the magnetic sensor has a recess provided on an outer surface side thereof.

9. The magnetic field detection device according to claim 1, further comprising:
a fixing implement for fixing the magnet to a needle of an analog meter, wherein
the housing is a housing of the analog meter,
the lid body has a structure replaceable with an existing lid body of the analog meter, and
the magnet is rotatable in a same plane view as the opening in plan view by being fixed to the needle by the fixing implement.
